(19) Europäisches Patentamt
European Patent Office
Office européen des brevets

(11) Veröffentlichungsnummer: **0 347 518**
**A1**

(12) **EUROPÄISCHE PATENTANMELDUNG**

(21) Anmeldenummer: 89101395.5

(22) Anmeldetag: 27.01.89

(51) Int. Cl.4: **H01L 21/314 , H01L 23/28**

Die Bezeichnung der Erfindung wurde geändert (Richtlinien für die Prüfung im EPA, A-III, 7.3).

(30) Priorität: 28.03.88 CH 1174/88

(43) Veröffentlichungstag der Anmeldung:
27.12.89 Patentblatt 89/52

(84) Benannte Vertragsstaaten:
**CH DE FR GB LI SE**

(71) Anmelder: **ASEA BROWN BOVERI AG**
**Haselstrasse**
**CH-5401 Baden(CH)**

(72) Erfinder: **Stockmeier, Thomas**
**Erbsackerweg 1048**
**CH-5303 Würenlingen(CH)**

(54) **Passivierung eines Halbleiterbauelementes.**

(57) Zur Passivierung eines Halbleiterbauelements wird ein Siliziumsubstrat (1) mit einer SIPOS-Schicht (2) und einer PSG-Schicht 4) bedeckt. Vorzugsweise wird die PSG-Schicht mit Bor dotiert (BPSG-Schicht).

FIG.1

## HALBLEITERBAUELEMENT

### TECHNISCHES GEBIET

Die Erfindung betrifft ein Halbleiterbauelement, umfassend ein Siliziumsubstrat und eine das Siliziumsubstrat bedeckende SIPOS-Schicht zur Passivierung des Halbleiterbauelements.

### STAND DER TECHNIK

Oberflächeneffekte dominieren oft die inneren Eigenschaften eines Halbleiterbauelements. Wenn sich z.B. bei einem PN-Uebergang Ionen an der Oberfläche des Halbleiters anlagern, werden im Inneren des Halbleiters Bildladungen induziert, welche die Charakteristik des PN-Uebergangs verändern. Um solche Effekte zu mindern, wird z.B. in der Planartechnologie die Oberfläche mit isolierendem Siliziumdioxid passiviert. Allerdings können auch hier unerwünschte Inversionsschichten induziert werden.

In neuerer Zeit werden Leistungshalbleiterbauelemente mit Hilfe einer SIPOS-Schicht (Semi-Insulating Polycristalline OxigendOped Silicon) passiviert. Die Eigenschaften solcher Schichten werden z.B. in Art. "Microstructure of implanted and rapid thermal annealed semi-insulating polycristalline oxigen-doped silicon", T.L. Alford et al., J. Electrochem. Soc: Solid-state science and technology, Vol. 134, No. 4, April 1987 diskutiert. Ihre Anwendung in der Passivierung von Leistungshalbleiterbauelementen wird z.B. in "Semi-Insulating Polycrystalline-Silicon (SIPOS) Passivation Technology", T. Matsushita et al., Supplement to Japanese Journal of Applied Physics, Vol. 15, 1976 gezeigt.

Die Wirkung der SIPOS-Schicht beruht wahrscheinlich auf ihrer vorhandenen aber sehr begrenzten Leitfähigkeit. So werden einerseits positiv geladene Ionen, die als Kontamination in der Umgebung vorhanden sind, abgeschirmt, und andererseits bleibt der Sperrstrom des Bauelements in tolerierbaren Grenzen.

Da SIPOS aber kein völlig dichtes Material ist, kann es längerfristig dennoch zur Verschlechterung der Sperreigenschaften des Bauelements kommen. Deshalb wird die SIPOS-Schicht zusätzlich noch mit einer Nitridschicht und/oder einer Oxidschicht abgedeckt.

Der Nachteil von Nitridschichten und auch von Siliziumoxidschichten ist ihre hohe mechanische Eigenspannung. Vornehmlich bei grösseren Schichtdicken kann es zu Rissen und anderen mechanischen Defekten kommen, was die beabsichtigte Wirkung dieser Schichten zunichte macht.

Dielektrische Schichten mit guten Fliesseigenschaften und geringen mechanischen Eigenspannungen werden seit einiger Zeit als Zwischenschichten bei der Herstellung von integrierten Schaltungen angewendet. Die Herstellung und die Eigenschaften solcher sogenannter BPSG-Schichten (Boro-Phosphosilicate Glasses) wird im Artikel "Borophosphosilicate Glasses for Integrated Circuits", W.Kern und K.Schmeltzer, Solid State Technology, June 1985 beschrieben.

### DARSTELLUNG DER ERFINDUNG

Aufgabe der Erfindung ist es, ein Halbleiterbauelement, umfassend ein Siliziumsubstrat und eine das Siliziumsubstrat bedeckende SIPOS-Schicht zur Passivierung des Halbleiterbauelements anzugeben, welches von den obengenannten Nachteilen frei ist.

Gemäss der Erfindung liegt die Lösung darin, dass auf der SIPOS-Schicht eine PSG-Schicht angeordnet ist.

Vorzugsweise ist die PSG-Schicht mit Bor dotiert.

Gemäss einem bevorzugten Herstellungsverfahren für eine solche Schichtabfolge werden sowohl die SIPOS-Schicht als auch die PSG-Schicht mit einem LPCVD-Verfahren hergestellt.

In den abhängigen Patentansprüchen sind weitere bevorzugte Ausführungsformen der Erfindung gekennzeichnet.

### KURZE BESCHREIBUNG DER ZEICHNUNG

Nachfolgend soll die Erfindung anhand von Ausführungsbeispielen und im Zusammenhang mit der Zeichnung näher erläutert werden. Es zeigt:

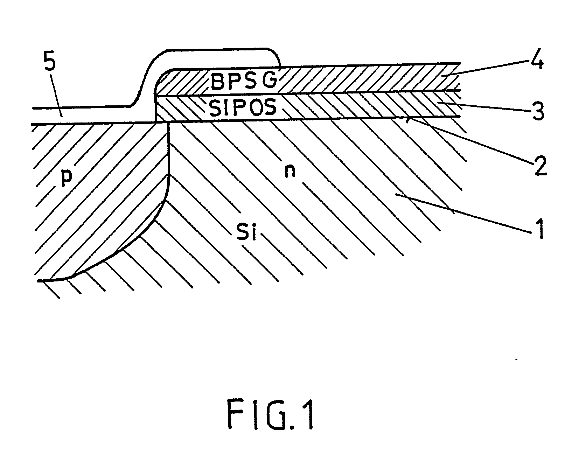

Fig. 1 eine erfindungsgemässe Schichtabfolge.

### WEGE ZUR AUSFÜHRUNG DER ERFINDUNG

Fig. 1 zeigt ein erfindungsgemässes Halbleiterbauelement. Es wird ausgegangen von einem Siliziumsubstrat 1, welches im Inneren bereits eine gewünschte Dotierungsstruktur aufweist. In Fig. 1 ist dies durch einen an eine Oberfläche 2 grenzenden PN-Uebergang angedeutet.

Zur Passivierung der Oberfläche 2 des Halbleiterbauelements wird nun folgende Schichtabfolge aufgebracht.

Direkt auf die Oberfläche 2 des Siliziumsubstrats 1 wird eine SIPOS-Schicht 3 abgeschieden. Dies kann auf bekannte Weise mit einem LPCVD-Verfahren (Low Pressure Chemical Vapor Deposition) gemacht werden. Dabei wird eine Reaktion von $SiH_4$ und $N_2O$ unter typischen Reaktionsbedingungen (z.B. 650 °C, 0.5 Torr) zum Abscheiden dieser Schicht verwendet. Ein Sauerstoffgehalt der SIPOS-Schicht 3 wird über das Verhältnis der Partialdrücke von $SiH_4$ zu $N_2O$ eingestellt.

Durch Einbringen von Phosphor in die SIPOS-Schicht 3 lässt sich der spezifische Widerstand dieser Schicht relativ genau einstellen, was sich positiv auf die Reproduzierbarkeit auswirkt.

Eine solche Dotierung der SIPOS-Schicht 3 mit Phosphor kann gleichzeitig mit dem Abscheiden (durch eine gezielte Zugabe von phosphorhaltigen Gasen zu den Reaktionsgasen $SiH_4$ und $N_2O$ resp. $CO_2$) oder nachträglich (etwa durch Ionenimplantation oder andere gängige Verfahren) geschehen.

Auf die SIPOS-Schicht 3 wird dann eine PSG-Schicht 4 abgeschieden. Bevorzugterweise wird dies ebenfalls mit einem LPCVD-Verfahren gemacht.

Der Zusatz von Phosphor vermindert dabei wesentlich die Eigenspannungen von Siliziumoxid. Man kann aus diesem Grund relativ dicke Schichten (0.5 - 1.5 μm) herstellen, ohne der Gefahr vermehrter mechanischer Defekte ausgesetzt zu sein.

Bei zu hoher Phosphorkonzentration zeigen sich aber an Aluminiumleiterbahnen, welche z.B. auf der PSG-Schicht 4 als Metallisierung 5 liegen, Korrosionserscheinungen. Deshalb wird vorzugsweise Phosphor zu einem gewissen Teil durch Bor substituiert. In diesem Fall spricht man von BPSG-Schichten.

Das Aufbringen der SIPOS-Schicht 3 und der PSG-Schicht 4 (resp. der BPSG-Schicht) erfolgt vorzugsweise mit einem LPCVD-Verfahren, denn dann lässt sich die erfindungsgemässe Schichtabfolge effizient während eines Prozessdurchlaufs herstellen. Es ist natürlich auch möglich die beiden Schichten in getrennten Prozessen abzuscheiden.

Wird die erfindungsgemässe Schichtabfolge zur Passivierung von Leistungshalbleiterbauelementen angewandt, so kann die erfindungsgemässe Passivierung auch für die besonders anfälligen Ränder und Kanten des Siliziumsubstrats 1 verwendet werden. In diesem Zusammenhang sind die bekannten, guten Fliesseigenschaften von PSG/BPSG von Vorteil.

Nach der erfindungsgemässen Passivierung wird, z.B. auf an sich bekannte Weise eine Metallisierung 5 auf dem Siliziumsubstrat 1 abgeschieden. Die Metallisierung 5 kann dabei die PSG-Schicht 4 teilweise überdecken, wie es Fig. 1 zeigt.

Abschliessend kann gesagt werden, dass die erfindungsgemässe Schichtabfolge für das Halbleiterbauelement einen guten Schutz gegen äussere Einflüsse (z.B. $Na^+$-Ionen) und eine hohe Zuverlässigkeit bietet.

## Ansprüche

1. Halbleiterbauelement, umfassend
a) ein Siliziumsubstrat (1)
b) und eine das Siliziumsubstrat (1) bedeckende SIPOS-Schicht (3) zur Passivierung des Halbleiterbauelements, dadurch gekennzeichnet, dass
c) auf der SIPOS-Schicht (3) eine PSG-Schicht (4) angeordnet ist.

2. Halbleiterbauelement nach Anspruch 1, dadurch gekennzeichnet, dass die PSG-Schicht (4) mit Bor dotiert ist (BPSG-Schicht).

3. Halbleiterbauelement nach Anspruch 2, dadurch gekennzeichnet, dass die SIPOS-Schicht (3) mit Phosphor dotiert ist.

4. Halbleiterbauelement nach Anspruch 1, dadurch gekennzeichnet, dass das Siliziumsubstrat (1) ein Leistungshalbleiterbauelement ist.

5. Verfahren zum Herstellen eines Halbleiterbauelements nach Anspruch 1, dadurch gekennzeichnet, dass die SIPOS-Schicht (3) und die PSG-Schicht (4) mit einem LPCVD-Verfahren hergestellt werden.

FIG.1

**Europäisches Patentamt**

**EUROPÄISCHER RECHERCHENBERICHT**

Nummer der Anmeldung

EP 89 10 1395

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | IEEE TRANSACTIONS ON ELECTRON DEVICES, Band ED-27, Nr. 2, February 1980, Seiten 340-343, IEEE, New York, US; R.W. COEN et al.: "A high-performance planar power MOSFET" * Figur 1; Seite 340, linke Spalte, letzter Absatz * | 1,4 | H 01 L 21/314 H 01 L 23/28 |
| Y | FR-A-2 487 576 (THOMSON-CSF) * Figur 2; Seite 4, Zeilen 10-26 * | 5 | |
| Y | FR-A-2 320 634 (GENERAL ELECTRIC) * Seite 12, Zeile 39 - Seite 13, Zeile 31 * | 5 | |
| A | US-A-4 420 765 (RCA CORP.) * Figur; Spalte 2, Zeilen 32-43; Spalte 3, Zeile 48 - Spalte 4, Zeile 42 * | 1-5 | |
| D,A | SOLID STATE TECHNOLOGY, Band 28, Nr. 6, Juni 1985, Seiten 171-179; W. KERN et al.: "Borophosphosilicate Glasses for Integrated Circuits" * Seite 172, rechte Spalte, letzter Absatz - Seite 176, Absatz 1 * | 2,5 | RECHERCHIERTE SACHGEBIETE (Int. Cl.4) H 01 L |
| A | EP-A-0 101 739 (HITACHI) * Zusammenfassung * | 3 | |
| A | TECHNICAL NOTES, Nr. 1239, 5. Mai 1980, Seite 1; J.P. WHITE: "Structure capable of withstanding high reverse energy" * Insgesamt * | 1,4 | |

Der vorliegende Recherchenbericht wurde für alle Patentansprüche erstellt

| Recherchenort | Abschlußdatum der Recherche | Prüfer |
|---|---|---|
| DEN HAAG | 11-07-1989 | GORI P. |